# EUROPEAN PATENT APPLICATION

(11) **EP 4 527 664 A1**
(43) Date of publication of application: **26.03.2025**
(21) Application number: 22945496.2
(22) Date of filing: 25.08.2022
(51) Int. Cl.: B60L 3/00

(54) **CONTROL METHOD AND APPARATUS FOR DRIVING ACTIVE SHORT CIRCUIT FOR ELECTRIC VEHICLE**

(30) Priority: 08.06.2022 CN 202210648061
(71) Applicant: Jee Automation Equipment (Shanghai) Co., Ltd., Shanghai 201805 (CN)
(72) Inventor: LIU, Lei, Shanghai 201805 (CN); YU, Haiyan, Shanghai 201805 (CN); JIAO, Minsheng, Shanghai 201805 (CN); CHEN, Feng, Shanghai 201805 (CN)
(74) Representative: Osterhoff, Utz
(86) International application number: PCT/CN2022/114713
(87) International publication number: WO 2023/236362

(57) **Abstract**

Disclosed is a control method of driving active short circuit for electric vehicles, including the following steps: outputting, by a power distribution unit, PDU controller, an active short circuit safety state enable signal and a PDU relay shut-off signal synchronously; in response to that the vehicle fails in a boost charging mode, making a motor control system exit the boost charging mode through the PDU relay shut-off signal; and after the motor control system exits the boost charging mode, making the motor control system enter an active short circuit safety state through the active short circuit safety state enable signal. The present application futher relates to an apparatus for driving active short circuit for electric vehicles. In practical application, the risk of a driving module being damaged caused by an electric motor controller in a boost charging mode entering an active short-circuit safety state by mistake due to a fault is solved.

## Description

The present application claims priority to Chinese Patent Application No. 202210648061.3, filed on June 08, 2022.

### TECHNICAL FIELD

The present application relates to the technical field of electric vehicles, and in particular to a control method and an apparatus of driving active short circuits for electric vehicles.

### BACKGROUND

With the rapid development of modern electric vehicle technology, 800V pure electric vehicles are the new trend in the current electric vehicle market. Most electric vehicles on the current market are 400V, and supporting facilities and charging piles are generally 400V standard. In order to promote the market application of 800V platform, the 800V drive platform is equipped with the boost charging function to solve the battery charging problem. At the same time, in order to save costs, the driving mode and the boost charging mode share the controller and the power module, and use the motor coil as the charging inductor of the boost charging mode. Under this premise, the vehicle has three working conditions that will affect the control strategy of the controller, namely the driving mode, the boost charging mode and the trailer mode, which brings new challenges to how the controller can achieve safe and reliable control in the three modes, and can still make effective responses especially in the case of failure where the controller cannot distinguish whether it is currently in the drive, the boost charging or the trailer mode. At the same time, in order to solve the charging problem, a power distribution unit (PDU) is usually configured. Since the unit is a high-voltage unit, a PDU management module is required to ensure the reliability and safety of the PDU. The controller usually manages several solenoid valves and monitors the voltage of each node of the high-voltage path.

The 800V platform is still a new technology in the market. The active short circuit control solution on the 400V platform cannot currently take into account the boost charging mode, and the fault working condition cannot make the system enter the active short circuit (ASC) state in the boost charging mode, which brings failure risks to the high-voltage drive module. There is no clear solution in the market yet.

### SUMMARY

The purpose of the present application is to provide a control method and an apparatus of driving active short circuit for electric vehicles to solve the risk of damage to the drive module caused by the motor controller mistakenly entering the active short circuit safety state due to a fault in the boost charging mode.

In order to solve the above problems, the present application provides a control method of driving active short circuit for electric vehicles, comprising the following steps:
outputting, by a power distribution unit, PDU controller, an active short circuit safety state enable signal and a PDU relay shut-off signal synchronously;
in response to that the vehicle fails in a boost charging mode, making a motor control system exit the boost charging mode through the PDU relay shut-off signal; and
after the motor control system exits the boost charging mode, making the motor control system enter an active short circuit safety state through the active short circuit safety state enable signal.

In an embodiment, the active short circuit safety state enable signal is transmitted lagged behind the PDU relay shut-off signal through a delay circuit.

In an embodiment, in response to that the vehicle is under a normal working condition and in the boost charging mode, the PDU controller is configured to output a PDU relay start signal and output synchronously to a motor controller, so as to lock an output of the active short circuit safety state; and
in response to that the vehicle fails in a driving mode, the motor control system is triggered to enter the active short circuit safety state based on a functional safety management signal.

In an embodiment, in response to that the vehicle is under the normal working condition and in the driving mode, the control method further includes:
outputting the PDU relay shut-off signal output by the PDU controller to a motor controller synchronously; and
in response to determining that the motor control system needs to enter the active short circuit safety state based on a bus voltage of the motor controller, making the motor control system enter the active short circuit safety state based on the active short circuit safety state enable signal.

In an embodiment, in response to that a connection of a connector between a motor controller and the PDU controller is unreliable, the control method further includes:
in response to determining that the motor control system needs to enter the active short circuit safety state based on a bus voltage of the motor controller and a current mode of the vehicle, making the motor control system enter the active short circuit safety state based on the active short circuit safety state enable signal.

In an embodiment, in response to that the vehicle is in a trailer mode, the control method further includes:
outputting the PDU relay shut-off signal output by the PDU controller to a motor controller synchronously; and
in response to determining that the motor control system needs to enter the active short circuit safety state based on a bus voltage of the motor controller, making the motor control system enter the active short circuit safety state based on the active short circuit safety state enable signal.

A control apparatus of driving an active short circuit for an electric vehicle, including:
a power distribution unit, PDU management unit configured to synchronously output an active short circuit safety state enable signal and a PDU relay shut-off signal, wherein the PDU relay shut-off signal is synchronously output to a motor controller;
a motor control unit configured to make a motor control system exit a boost charging mode based on the PDU relay shut-off signal; and
an active short circuit safety state trigger unit configured to make the motor control system enter an active short circuit safety state based on the active short circuit safety state enable signal after the motor control system exits the boost charging mode.

In an embodiment, the control apparatus of driving the active short circuit for the electric vehicle further includes:
a signal delay unit configured to make the active short circuit safety state enable signal lag behind a transmission of the PDU relay shut-off signal, so that after the motor control system exits the boost charging mode, the motor control system is configured to enter the active short circuit safety state based on the active short circuit safety state enable signal.

In an embodiment, the control apparatus of driving the active short circuit for the electric vehicle further includes:
an active short circuit safety state locking unit configured to lock an output of the active short circuit safety state in response to that the a PDU relay start signal is output by the PDU management unit.

In an embodiment, the control apparatus of driving the active short circuit for the electric vehicle further includes:
a functional safety management unit configured to send a functional safety management signal in response to that the vehicle fails in a driving mode;
wherein the active short circuit safety state trigger unit is further configured to trigger the motor control system to enter the active short circuit safety state based on the functional safety management signal.

In an embodiment, the control apparatus of driving the active short circuit for the electric vehicle further includes:
a determination unit configured to determine whether the motor control system needs to enter the active short circuit safety state based on a bus voltage of the motor controller in response to that the vehicle is in the driving mode or a trailer mode and under a normal working condition.

In an embodiment, the determination unit is further configured to determine whether the motor control system needs to enter the active short circuit safety state based on the bus voltage of the motor controller and a current mode of the vehicle in response to that a connection of a connector between the motor controller and a PDU controller is unreliable.

An electric vehicle, including the control apparatus of driving the active short circuit.

In the above technical solution, the present application solves the risk of damage to the drive module caused by the motor controller mistakenly entering the active short circuit (ASC) safety state due to a fault in the boost charging mode; distinguishes overvoltage in the trailer mode and the boost charging mode, so that the hardware enters the corresponding correct protection mode; and provides a simple implementation method with a relatively low cost, avoiding the logical risks caused by the complex circuit design.

Other features and advantages of the present application will be explained in the subsequent description, and part of them will become obvious from the description, or be understood by implementing the present application. The purpose and other advantages of the present application can be achieved and obtained by the structures indicated in the description, claims and drawings.

### BRIEF DESCRIPTION OF THE DRAWINGS

In order to illustrate the technical solutions in the embodiments of the present application or in the related art more clearly, the following briefly introduces the accompanying drawings required for the description of the embodiments or the related art. Obviously, the drawings in the following description are only part of embodiments of the present application. For those skilled in the art, other drawings can also be obtained according to the structures shown in these drawings without any creative effort.
FIG. 1 shows a schematic view of a logic circuit according to an embodiment of the present application.
FIG. 2 shows a schematic view of a signal output circuit according to an embodiment of the present application.

### DETAILED DESCRIPTION OF THE EMBODIMENTS

In order to make the purpose, technical scheme and advantages of the present application clearer, the technical solutions of the embodiments of the present application will be described in more detail below with reference to the accompanying drawings. It is obvious that the embodiments to be described are only some rather than all of the embodiments of the present application.

All other embodiments obtained by those skilled in the art based on the embodiments of the present application without creative efforts shall fall within the scope of the present application.

According to an embodiment of the present application, the control method of driving active short circuit for electric vehicle includes the steps of: outputting, by the power distribution unit (PDU) controller, the active short circuit safety state enable signal and the PDU relay shut-off signal synchronously. The PDU relay shut-off signal output by the PDU controller is synchronously output to the motor controller.

The control method for different working conditions is as follows.
1. In response to that the vehicle fails in the boost charging mode (in overvoltage state): outputting, by the PDU relay, the shut-off signal, so that the motor control system exits the boost charging mode; and after the motor control system exits the boost charging mode, outputting the active short circuit safety state enable signal so that the motor control system enters the active short circuit safety state.
2. In response to that the vehicle is under a normal working condition and in the boost charging mode: outputting, by the PDU controller, the PDU relay start signal; and synchronously outputting to the motor controller to lock the output of the active short circuit safety state.
3. In response to that the vehicle fails in the driving mode and the overvoltage state is generated: triggering the motor control system to enter the active short circuit safety state based on the functional safety management signal.
4. In response to that the vehicle is under the normal working condition and in the driving mode: in response to that it is determined that the motor control system needs to enter the active short circuit safety state based on the bus voltage of the motor controller, making the motor control system to enter the active short circuit safety state based on the active short circuit safety state enable signal.
5. In response to that the connection of the connector between the motor controller and the PDU controller is unreliable: in response to that it is determined that the motor control system needs to enter the active short circuit safety state based on the bus voltage of the motor controller and the current mode of the vehicle, making the motor control system enter the active short circuit safety state based on the active short circuit safety state enable signal.
6. In response to that the vehicle is in the trailer mode: in response to that it is determined that the motor control system needs to enter the active short circuit safety state based on the bus voltage of the motor controller, making the motor control system enter the active short circuit safety state based on the active short circuit safety state enable signal.

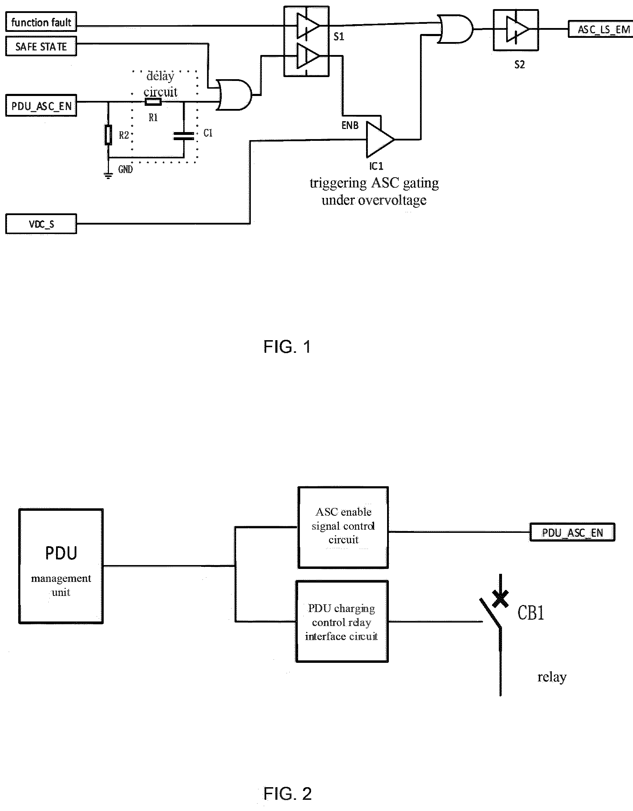

As shown in FIG. 1, the logic circuit schematic view includes two circuits for executing the active short circuit installation state. In the first circuit, in response to that a function fault signal is issued, and after function fault signal passes through isolation units S1 and S2, the active short circuit safety state execution (ASC_LS_EM) signal is directly triggered; in the second circuit, the ASC_LS_EM signal is selected to be triggered through the logic tri-state gate IC1. Since the output results of the two circuits are consistent, the first logic OR gate is adopted to reduce the complexity of the circuit.

As shown in FIG. 2, the PDU management micro controller unit (MCU) of the PDU controller outputs the active short circuit safety state enable (PDU_ASC_EN) signal through the ASC enable signal control circuit, and outputs the PDU relay shut-off signal of the charging control relay CB1 through the PDU charging control relay interface circuit at the same time, thereby realizing the synchronous output of the PDU_ASC_EN signal and the PDU relay shut-off signal.

Combined with the logic circuit view shown in FIG. 1, the specific logic of the above working conditions is as follows:
Under the third working condition, in response to that a fault occurs in the driving mode and an overvoltage state is generated, the motor control system is triggered by the functional safety management (SAFE STATE) signal to enter the active short circuit safety state. Since the logic of the PDU_ASC_EN signal is consistent with the logic of the SAFE STATE signal, the second logic OR gate is adopted to reduce the circuit complexity.

Under the second working condition, the PDU controller outputs the PDU relay start signal with a logic high level, the logic high level is synchronously output to the motor controller, and the motor controller works normally. At this time, the PDU_ASC_EN signal and the SAFE STATE signal are not output, the logic tri-state gate IC1 is in the cut-off state, thereby locking the output of the active short circuit safety state.

Under the first working condition, in response to that the vehicle fails in the boost charging mode, the PDU controller synchronously outputs the PDU_ASC_EN signal and the PDU relay shut-off signal. The PDU relay shut-off signal is a logic low level and is synchronously output to the motor controller to make the motor control system exit the boost charging mode. The PDU_ASC_EN signal lags behind the PDU relay shut-off signal through the delay circuit. After passing through the isolation unit S1, the logic tri-state gate is turned on, thereby triggering the ASC gating under the overvoltage in the boost charging mode, that is, triggering the ASC_LS_EM signal. This ensures that the motor control system will not enter the ASC state in the boost charging mode.

As shown in FIG. 1, the delay circuit is the RC circuit, which acts as a filter and also provides delay for the signal. The RC circuit includes a resistance R1, a resistance R2 and a capacitor C1. Both ends of the R1 are connected between the PDU_ASC_EN signal and the second logic OR gate, the first end of the R2 is connected between the R1 and the the PDU_ASC_EN signal, the second end of the R2 is grounded, the first end of the C1 is connected between the R1 and the second logic OR gate, and the second end of the C1 is connected to the second end of the R2.

Under the fourth working condition and the sixth working condition, in response to that the vehicle is in the driving mode or the trailer mode and under normal working conditions, the PDU controller outputs the PDU relay shut-off signal, i.e., the logic low level and outputs synchronously to the motor controller, and determines whether the motor control system needs to enter the active short circuit safety state based on the bus voltage of the motor controller.

Under the fifth working condition, in response to that the connection of the connector between the motor controller and the PDU controller is unreliable, the control port is configured as low level. Since the voltage threshold for entering the active short circuit safety state is different in different modes of the vehicle, whether the motor control system needs to enter the active short circuit safety state is controlled by the bus voltage of the motor controller and the current vehicle mode.

Under the fourth working condition, the fifth working condition and the sixth working condition, whether the motor control system needs to enter the active short circuit safety state is determined based on the bus voltage of the motor controller. Specifically, in response to that the bus voltage of the motor controller exceeds the first threshold voltage in the driving mode, the motor control system is triggered to enter the active short circuit safety state; in response to that the bus voltage of the motor controller is higher than the second threshold voltage in the trailer mode, the motor control system is triggered to enter the active short circuit safety state.

As shown in FIG. 1, VDC_S is the bus voltage of the motor controller. Under normal working conditions, the logic tri-state gate is closed and VDC_S cannot affect the ASC logic. Under trailer working conditions, after the low-voltage test is powered off, since the high-voltage test has power (in the vehicle-mounted drive motor control system, the low voltage refers to the electronic unit or circuit powered by the 12V or 24V battery on the vehicle, and the high voltage refers to the power battery, usually 380V-800V powered electronic modules and units. Since the two power supply systems cannot have a physical path, isolation units S1 and S2 realize high and low voltage connection through magnetic field coupling), in response to that VDC_S is higher than the threshold, ASC can be triggered, that is, high-speed trailers can trigger ASC to avoid power module failure in the trailer mode.

The present application also provides a control apparatus of driving active short circuit for electric vehicle, including:
a PDU management unit configured to synchronously output an active short circuit safety state enable signal and a PDU relay shut-off signal;
a motor control unit configured to make the motor control system exit the boost charging mode based on the PDU relay shut-off signal;
an active short circuit safety state trigger unit configured to make the motor control system enter the active short circuit safety state based on the active short circuit safety state enable signal after the motor control system exits the boost charging mode;
a signal delay unit configured to make the active short circuit safety state enable signal lag behind the transmission of the PDU relay shut-off signal, so that after the motor control system exits the boost charging mode, the motor control system enters the active short circuit safety state based on the active short circuit safety state enable signal;
an active short circuit safety state locking unit configured to lock the output of the active short circuit safety state in response to that the PDU management unit outputs the PDU relay start signal;
a functional safety management unit configured to issue a functional safety management signal in response to that a fault occurs in the driving mode of the vehicle; the active short circuit safety state trigger unit is also configured to trigger the motor control system to enter the active short circuit safety state based on the functional safety management signal output by the functional safety management unit; and
a determination unit configured to determine whether the motor control system needs to enter the active short circuit safety state based on the bus voltage of the motor controller in response to that the vehicle is in the driving mode or the trailer mode under normal working conditions; the determination unit is also configured to determine whether the motor control system needs to enter the active short circuit safety state based on the bus voltage of the motor controller and the current vehicle mode in response to that the connection of the connector between the motor controller and the PDU controller is unreliable.

The implementation process of the functions and effects of the above module unit can be found in the implementation process of the corresponding steps in the control method of driving active short circuit for electric vehicle in the above embodiment of the present application, which will not be repeated. The present application also provides an electric vehicle, including the control apparatus for driving active short circuit in the above embodiment.

The above are only embodiments of the present application and are not intended to limit the present application in any form. Although the present application has been disclosed as embodiments above, they are not intended to limit the present application. For those skilled in the art, without deviating from the technical scheme of the present application, when the technical content disclosed above can be used to make some changes or modifications into equivalent embodiments of equivalent changes, any content that does not deviate from the technical scheme of the present application and any simple modification, equivalent changes and modifications made to the above embodiments according to the technical substance of the present application shall still fall within the scope of the present application.

## Claims

1. A control method of driving an active short circuit for an electric vehicle, **characterized by** comprising:
outputting, by a power distribution unit, **PDU** controller, an active short circuit safety state enable signal and a **PDU** relay shut-off signal synchronously;
in response to that the vehicle fails in a boost charging mode, making a motor control system exit the boost charging mode through the **PDU** relay shut-off signal; and
after the motor control system exits the boost charging mode, making the motor control system enter an active short circuit safety state through the active short circuit safety state enable signal.

2. The control method of driving the active short circuit for the electric vehicle according to claim 1, wherein the active short circuit safety state enable signal is transmitted lagged behind the PDU relay shut-off signal through a delay circuit.

3. The control method of driving the active short circuit for the electric vehicle according to claim 1, wherein
in response to that the vehicle is under a normal working condition and in the boost charging mode, the PDU controller is configured to output a PDU relay start signal and output synchronously to a motor controller, so as to lock an output of the active short circuit safety state; and
in response to that the vehicle fails in a driving mode, the motor control system is triggered to enter the active short circuit safety state based on a functional safety management signal.

4. The control method of driving the active short circuit for the electric vehicle according to claim 1, wherein in response to that the vehicle is under the normal working condition and in the driving mode, the control method further comprises:
outputting the PDU relay shut-off signal output by the PDU controller to a motor controller synchronously; and
in response to determining that the motor control system needs to enter the active short circuit safety state based on a bus voltage of the motor controller, making the motor control system enter the active short circuit safety state based on the active short circuit safety state enable signal.

5. The control method of driving the active short circuit for the electric vehicle according to claim 1, wherein in response to that a connection of a connector between a motor controller and the PDU controller is unreliable, the control method further comprises:
in response to determining that the motor control system needs to enter the active short circuit safety state based on a bus voltage of the motor controller and a current mode of the vehicle, making the motor control system enter the active short circuit safety state based on the active short circuit safety state enable signal.

6. The control method of driving the active short circuit for the electric vehicle according to claim 1, wherein in response to that the vehicle is in a trailer mode, the control method further comprises:
outputting the PDU relay shut-off signal output by the PDU controller to a motor controller synchronously; and
in response to determining that the motor control system needs to enter the active short circuit safety state based on a bus voltage of the motor controller, making the motor control system enter the active short circuit safety state based on the active short circuit safety state enable signal.

7. A control apparatus of driving an active short circuit for an electric vehicle, **characterized by** comprising:
a power distribution unit, PDU management unit configured to synchronously output an active short circuit safety state enable signal and a PDU relay shut-off signal, wherein the PDU relay shut-off signal is synchronously output to a motor controller;
a motor control unit configured to make a motor control system exit a boost charging mode based on the PDU relay shut-off signal; and
an active short circuit safety state trigger unit configured to make the motor control system enter an active short circuit safety state based on the active short circuit safety state enable signal after the motor control system exits the boost charging mode.

8. The control apparatus of driving the active short circuit for the electric vehicle according to claim 7, further comprising:
a signal delay unit configured to make the active short circuit safety state enable signal lag behind a transmission of the PDU relay shut-off signal, so that after the motor control system exits the boost charging mode, the motor control system is configured to enter the active short circuit safety state based on the active short circuit safety state enable signal.

9. The control apparatus of driving the active short circuit for the electric vehicle according to claim 7, further comprising:
an active short circuit safety state locking unit configured to lock an output of the active short circuit safety state in response to that the a PDU relay start signal is output by the PDU management unit.

10. The control apparatus of driving the active short circuit for the electric vehicle according to claim 7, further comprising:
a functional safety management unit configured to send a functional safety management signal in response to that the vehicle fails in a driving mode;
wherein the active short circuit safety state trigger unit is further configured to trigger the motor control system to enter the active short circuit safety state based on the functional safety management signal.

11. The control apparatus of driving the active short circuit for the electric vehicle according to claim 7, further comprising:
a determination unit configured to determine whether the motor control system needs to enter the active short circuit safety state based on a bus voltage of the motor controller in response to that the vehicle is in the driving mode or a trailer mode and under a normal working condition.

12. The control apparatus of driving the active short circuit for the electric vehicle according to claim 11, wherein the determination unit is further configured to determine whether the motor control system needs to enter the active short circuit safety state based on the bus voltage of the motor controller and a current mode of the vehicle in response to that a connection of a connector between the motor controller and a PDU controller is unreliable.
